## Europäisches Patentamt
## European Patent Office
## Office européen des brevets

(11) Publication number: **0 134 789**
**B1**

# EUROPEAN PATENT SPECIFICATION

(45) Date of publication of patent specification: **06.07.88**

(51) Int. Cl.⁴: **G 03 F 7/26**

(21) Application number: **84900368.6**

(22) Date of filing: **19.12.83**

(86) International application number:
**PCT/US83/01993**

(87) International publication number:
**WO 84/02986 02.08.84 Gazette 84/18**

(54) **BILEVEL ULTRAVIOLET RESIST SYSTEM FOR PATTERNING SUBSTRATES OF HIGH REFLECTIVITY.**

(30) Priority: **24.01.83 US 460406**

(43) Date of publication of application:
**27.03.85 Bulletin 85/13**

(45) Publication of the grant of the patent:
**06.07.88 Bulletin 88/27**

(84) Designated Contracting States:
**DE FR NL**

(56) References cited:
JP-A-57 032 635
US-A-4 211 834
US-A-4 262 809
US-A-4 352 870
US-A-4 370 405
US-A-4 373 018
US-A-4 394 437
IEEE TRANSACTIONS ON ELECTRON DEVICES, issued November 1981, IWAYANAGI et al.: "AZIDE-PHENOLIC RESIN PHOTORESISTS FOR DEEP UV LITHOGRAPHY", pp 1306-1310
PROCEEDINGS OF KODOAK

(73) Proprietor: **AMERICAN TELEPHONE AND TELEGRAPH COMPANY**
**550 Madison Avenue**
**New York, NY 10022 (US)**

(72) Inventor: **ONG, Edith, Ting, Ting**
**89 Chestnut Hill Drive**
**Murray Hill, NJ 07974 (US)**

(74) Representative: **Johnston, Kenneth Graham et al**
**AT&T (UK) LTD. AT&T Intellectual Property Division 5 Mornington Road Woodford Green Essex, IG8 OTU (GB)**

(56) References cited:
MICROELECTRONICS SEMINAR, issued 15 October 1981. ONG et al.: "BILEVEL PHOTORESIST PROCESSING TECHNIQUES FOR FINELINE LITHOGRAPHY", pp 91-97
IBM TECHNICAL DISCLOSURE BULLENTIN, issued December 1980, BASSOUS et al.: "ACRIDINE...MICROLITHOGRAPHY", pp 3387-3390

JOURNAL OF VACUUM SCIENT & TECHNOLOGY, issued September 1980, TAI et al.: "SUBMICRON...SCHEME", pp 1169-1176

Courier Press, Leamington Spa, England.

## Description

This invention relates to a method for making semiconductor devices comprising the steps of coating a substrate to be processed with a lower layer of photoresist, coating the lower layer with an upper layer of photoresist, using optical apparatus to project a focused image of first ultraviolet light on the upper layer, the substrate being reflective of the first ultraviolet light, developing the upper layer to form a first mask, exposing the masked lower layer to second ultraviolet light, developing the lower layer to form a second mask, and thereafter processing the substrate.

In the manufacturing of devices such as semiconductor integrated circuits, patterning (by geometrically selectively etching) a top surface layer of a substrate in accordance with a desired configuration is typically accomplished using a patterned protective layer comprising a patterned photoresist (photosensitive etch resistant material), which is located in contact with the top surface of the substrate. The photoresist layer is patterned in accordance with the desired configuration of patterning of the top surface of the substrate, and the thus patterned photoresist layer serves as a geometrically selective protective mask against etching the top surface of the substrate. The photoresist layer itself is typically patterned by first geometrically selectively illuminating it with a pattern of optical (or photo) radiation. The pattern is arranged to produce in the photoresist layer a pattern of bright and dark regions in accordance with the ultimately desired substrate surface pattern (or its complement, as explained more fully below). Then the photoresist is developed by treating it with a solvent, which develops the resist by selectively dissolving it in accordance with the pattern of radiation.

A photoresist can be either a "positive" photoresist (dissolves where previously illuminated by photoradiation) or a "negative" photoresist (dissolves where not previously illuminated). In any event, it should be of sufficient thickness to avoid pinhole problems (typically a thickness of at least 0.4 micron or more). Accordingly, the layer of photoresist after development is patterned in accordance with the pattern (positive photoresist) or complementary pattern (negative photoresist) of the radiation. Using the thus patterned layer of photoresist as a protective mask against etching, the top surface layer of the substrate is patterned by selective removal of portions thereof in accordance with the pattern of the photoresist by means of a treatment with an etchant which attacks the material of the top surface layer of the substrate but not the material of the photoresist. In this way, the top surface layer of the substrate is patterned in the desired configuration, the pattern (or complement thereof) of the optical radiation having been imparted to the photoresist, and thence the resulting pattern of the photoresist having been imparted to the top surface layer of the substrate.

Optical radiation used thus to define the pattern in a photoresist is typically in the near ultraviolet (wavelength range between about 3000 and $4000 \times 10^{-10}$M or deep ultraviolet (wavelength between about 2000 and $3000 \times 10^{-10}$M), in order to achieve submicron pattern definition (feature size). In any event, optical diffraction effects limit the feature size to approximately one wavelength or more, depending upon the nature and geometry of the optical system used for defining the pattern.

As known in the art, there are problems associated with imparting the desired pattern to the photoresist from the optical radiation, depending upon the details of the method used therefor. There are three typical such methods: optical contact printing, optical proximity printing, and optical projection printing. The first two have limitations that will not be discussed herein.

In the technique of optical projection printing, an optical projection system, typically comprising lenses and/or mirrors, is used to focus the resulting projected optical beam of radiation as an image in the photoresist. This image has a pattern of bright and dark regions, as determined by the projection system, in accordance with the ultimately desired pattern to be imparted to the surface of the substrate. A major problem here, encountered in case the top surface of the substrate is not planar, is a blurring of the image, and hence an undesirable blurring or spreading of the ultimate photoresist pattern, caused by a nonvanishing depth of optical image focus which is less than the height of steps (nonplanarity) of the top surface of the substrate. This problem can be mitigated by using a bilevel photoresist system, that is, two layers of photoresists of different materials, one layer on top of and in contact with the other. Both layers advantageously have flat (planar) top major surfaces. In order for the bottom photoresist layer to have a flat top major surface (to be contacted by the top layer), the bottom layer has a sufficiently large thickness to enable formation of the flat (planar) top surface. In order to avoid problems caused by nonvanishing depth of focus, the top layer of photoresist has a sufficiently small (and uniform) thickness, typically about $0.5 \times 10^{-6}$M (i.e., less than the depth of image focus). For submicron feature definition or resolution (less than one micron) of the pattern, both photoresist layers are sensitive to ultraviolet (UV) radiation.

For example, U.S.—A—4,211,834 issued to Lapadula et al on July 8, 1980, entitled "Method of Using O-Quinone Diazide Sensitized Phenol-Formaldehyde Resist as a Deep Ultraviolet Light Exposure Mask", teaches a bilevel photoresist system of organic materials composed of: (1) a bottom layer of positive photoresist which is sensitive to deep ultraviolet optical radiation but which is both not sensitive and not opaque to near ultraviolet (near UV) radiation ($\lambda$ between about 3000 and $4000 \times 10^{-10}$M), such as a layer of PMMA (polymethyl methacrylate), and (2) a top layer of photoresist of organic material which is opaque to deep ultraviolet optical radiation ($\lambda$ between about 2000 and $3000\times10^{-10}$M) but which is sensitive but not opaque to near UV, such as a phenol-formaldehyde photoresist. This bilevel system is formed upon the top surface of a substrate to be patterned. The system is first exposed to a first optical beam in the form of a projected optical beam focused to an image pattern of bright and dark regions in the top layer. The beam, and hence the resulting bright regions of the image, has significant amounts of radiant energy in the near ultraviolet range. The top layer is developed with a solvent that attacks and dissolves portions of the top layer in accordance with the focused image pattern—that is, portions corresponding to bright regions of the image are removed, portions corresponding to dark regions remain intact. Then a second beam in the form of a collimated (parallel) beam of unpatterned optical radiation is directed at the bottom layer through the top (now patterned) layer. The beam of collimated radiation then everywhere floods the top surface of the intact portion of the top layer and of the then exposed portions of the bottom layer, but significant amounts of this radiation cannot reach those portions of the bottom layer located underneath intact portions of the top layer, because the top layer is opaque to deep UV. This collimated beam contains significant amounts of deep UV radiation at wavelengths below $2600\times10^{-10}$M to which the bottom photoresist layer, but not the top photoresist layer, is sensitive. Accordingly, development by a solvent that selectively dissolves only the exposed portions of the bottom photoresist layer results in a patterning of the bottom layer in accordance with the previous patterning of the top photoresist layer and hence in accordance with the image pattern of the first projected optical beam. Then the top surface layer of the substrate underlying the bottom photoresist layer can be patterned by an etching process using the bottom (and top) layer(s) of the thus patterned photoresist system as a protective mask against the etching.

A major problem with the foregoing bilevel system stems from reflection of the projected near UV radiation by the top surface of the substrate. Such reflection produces a standing wave optical pattern, particularly in the top photoresist layer, which produces in the top photoresist layer an undesirable standing wave pattern of bright regions or spots in the top layer which are located at areas where it should be dark for proper pattern definition. The problem arises, for example, in systems where the top surface layer of the substrate is aluminum, which is highly reflecting in the ultraviolet. This problem can be mitigated by using for the top layer—instead of an organic material—an inorganic negative photoresist layer such as germanium-selenium as described, for example, by K. L. Tai, et al, "Submicron Optical Lithography Using an Inorganic Resist/Polymer Bilevel Scheme", *Journal of Vacuum Scientific Technology*, Vol. 17, pp. 1169—1176, (1980). However, such an inorganic layer requires an expensive vacuum deposition step instead of a relatively inexpensive process of spinning-on photoresists which are made of organic materials. Therefore, it would be desirable to have a completely organic bilevel ultraviolet photoresist system which avoids the standing wave problem caused by substrate reflectivity.

Similar methods to U.S. Patent 4,211,834 are disclosed in IBM Disclosure Bulletin 23 No. 7B Dec. 1980 pages 3387—3390; and in Proceedings of Kodak Microelectronics Seminar issued 15.10.81 pages 91—97.

IEEE Transactions on Electron Devices issued November 1981 pages 1306—1310 discloses the use in lithography of an azide-phenolic resin of diazo diphenyl sulfone mixed with poly(p-vinylphenol).

In any bilevel photoresist system, it is also important that each layer should be selected so as not to cause interface problems with the neighboring underlying layer, that is, problems at an interface of the two layers where there is a blending of the photoresist materials of the two layers which would hinder proper development of the underlying layer.

These problems are solved in accordance with the invention which provides a method of making semiconductor devices comprising the steps of coating a substrate to be processed with a lower layer of photoresist, coating the lower layer with an upper layer of photoresist consisting of an organic material, using optical apparatus to project a focused image of first ultraviolet light on the upper layer, the substrate being reflective of the first ultraviolet light, developing the upper layer to form a first mask, exposing the masked lower layer to second ultraviolet light, developing the lower layer to form a second mask, and thereafter processing the substrate characterised in that the first ultraviolet light has a wavelength in the deep ultraviolet range, the upper layer is a negative photoresist consisting essentially of an azide-phenolic resin of diazodiphenyl sulfone mixed with poly(p-vinylphenol), is sufficiently thin to be within the depth of focus of the optical apparatus at the deep ultraviolet wavelength, is sensitive to deep ultraviolet light, and has a sufficient thickness to be opaque to the deep ultraviolet light.

In the drawing:

Fig. 1 is a view in cross section of a bilevel deep ultraviolet photoresist system for patterning a substrate in accordance with a specific embodiment of the invention;

Figs. 2 through 6 illustrate in cross section the bilevel system of Fig. 1 during various successive steps of patterning a substrate in accordance with a specific embodiment of the invention.

A bilevel organic photoresist system located upon a top surface of an optically reflecting substrate comprises a top organic negative photoresist layer which is sensitive to deep ultraviolet (UV) radiation, and is at the same time substantially opaque to both deep and near UV radiation, together with a bottom organic positive photoresist layer which is sensitive to either deep or near (or both) UV radiation. Advantageously, both the top and bottom photoresist layers are made of materials which are sensitive to a given deep ultraviolet wavelength, or to a given group or band of wavelengths, so that the same UV source can be used for patterning both the top and the bottom photoresist layers. By "substantially opaque" is meant that the thickness of the (top) photoresist layer is sufficient to reduce the intensity of the deep ultraviolet radiation after propagating through the layer to less than about 10% of its initial (incident) value; that is, the UV intensity at the bottommost portions of top photoresist layer is not enough to produce any significant sensitizing and hence any significant effect on the patterning of the bottom layer by subsequent development (in solvent, for example). Thus, in particular, after propagating through the bottom photoresist layer and reflection by the top surface of the reflecting substrate, the amount of deep UV which is available for producing undesirable standing waves in the top photoresist layer is too small to cause any significant undesirable effect on the patterning of the top photoresist layer. On the other hand, the thickness of the negative photoresist layer is advantageously sufficiently small so as to be within the depth of focus of deep UV radiation, typically a thickness in the approximate range of 0.4 to $0.8 \times 10^{-6}$M. An organic photoresist material that has been found to be thus suitable for the top photoresist layer is an azide-phenolic resin: specifically, diazidodiphenyl sulfone, a photosensitive azide compound, mixed with the phenolic resin poly(p-vinylphenol), sold as "Raycast RD2000N" by Hitachi Chemical Company America, Ltd. and described in greater detail as "MRS-1" in a paper entitled "Azide-Phenolic Resin Photoresists for Deep UV Lithography" by T. Iwayanagi et al, published in *IEEE Transactions on Electron Devices,* Vol. ED-28, No. 11, (Nov. 1981), pp. 1306—1310. A thickness of about 0.5 to 0.6 micron of this azide compound is useful and is substantially opaque to deep UV. The bottom photoresist layer can be PMMA (polymethyl methacrylate), for example, or other positive photoresist of organic material sensitive to deep UV radiation advantageously which can be produced by the same UV source as that which can be used for sensitizing the top photoresist layer. In this case the deep UV source used for patterning the top layer should not also contain substantial amounts of near UV radiation to which both the top layer is not opaque and the bottom photoresist layer is photosensitive. Appropriate optical filters can be used for thus suppressing such near UV radiation.

This invention's use of a negative photoresist for the top layer of a bilevel photoresist system alleviates the above-mentioned interface problem encountered when both layers are positive photoresists (positive upon positive photoresist systems). This problem does not arise in a negative upon positive photoresist system because the solvent used for patterning the top (negative) layer is designed to remove only the nonilluminated portions of the negative photoresist; i.e., no photochemical change in the top layer occurs or is needed at portions thereof where removal thereof by the solvent is desired. In the positive upon positive photoresist system, however, the solvent for the top layer is designed to remove only the portions of the top photoresist material which have been illuminated and have thereby undergone photochemical change; and hence at the interface of the top and bottom photoresists, where there is a blending of top and bottom photoresist materials, there are photochemical reaction products (of blended material) which can be sufficiently different (from the unblended material) as to inhibit proper dissolving of the top photoresist material at the interface, whereby subsequent development of the bottom layer is undesirably inhibited.

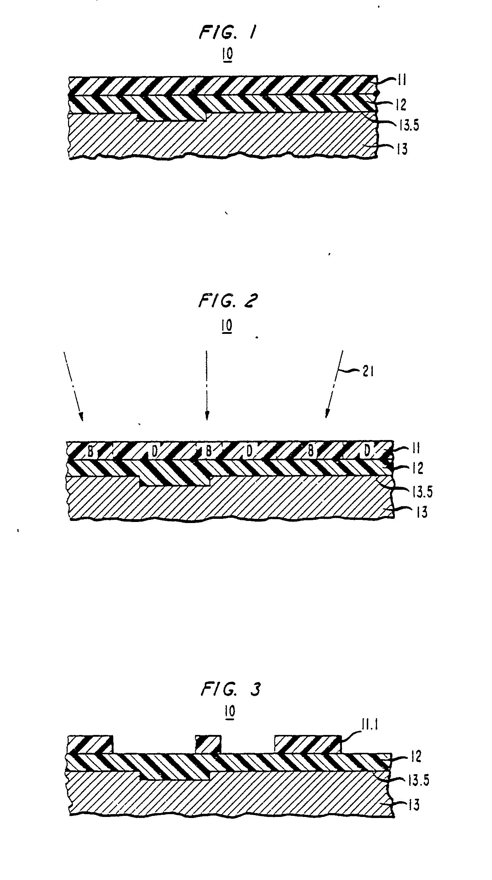

Referring now to the drawing, Fig. 1 shows a bilevel photoresist system 10 for deep ultraviolet photolithography comprising a top negative photoresist layer 11 of organic material located upon a bottom positive photoresist layer 12 of another organic material located upon a top surface 13.5 of a substrate 13 to be patterned by deep ultraviolet photolithography. The substrate 13 is essentially aluminum, which is reflective of the deep UV radiation to be used. The aluminum substrate 13 is typically formed as the top layer of an underlying silicon integrated circuit (not shown). Other reflective metals or metal-like materials may be used instead of aluminum, such as gold, platinum, or metal silicide.

The negative photoresist layer is essentially an azide-phenolic resin which is photosensitive to all wavelengths in a second set of deep UV wavelengths. A deep UV optical beam is projected through a patterned opaque mask and directed onto the top surface of the negative photoresist layer where the beam is focused as an optical image in this negative layer. This image has a pattern of bright and dark regions which corresponds to the complement of the desired pattern of areas to be removed from the top surface of the substrate (the bright regions of the image overlying areas of the substrate not to be removed, the dark regions overlying areas to be removed). The beam (unavoidably) contains radiation of at least one wavelength $\lambda_1$ of the second set to which the positive photoresist is also sensitive (i.e., $\lambda_1$ is also in the first set). The negative photoresist advantageously is made sufficiently thick to be opaque to any such wavelength as $\lambda_1$, in order to prevent UV light of such wavelength(s) from entering the positive photoresist layer in regions thereof where it would undesirably sensitive this positive layer. The beam also (unavoidably) contains at least one other wavelength $\lambda_2$ of the second set to which the positive photoresist layer 12 is not photosensitive but not opaque and of which the substrate is reflective; and therefore the negative photoresist layer advantageously is made sufficiently thick to be opaque to any such wavelength as $\lambda_2$, in order to suppress the standing wave problem. Furthermore, the negative photoresist layer advantageously is made sufficiently thin so that it is within the depth of focus of all the wavelengths of the second set that are contained in the beam, in order to avoid blurring of the image in this photoresist layer.

The bottom photoresist layer 12 is a positive photoresist sensitive to the deep UV, such as PMMA having a (minimum) thickness of about $1\times10^{-6}$m. This layer is typically formed on the top surface 13.5 of the substrate 13 by spin coating with PMMA (9% in chlorobenzene) using a spin speed of about 5000 rpm. After baking at about 150°C for about 60 minutes, a photosensitive azide (diluted in the ratio of about 7 parts azide compound to: 3 parts cyclohexanone) is spun onto the top surface of the PMMA using a spin speed of about 6000 rpm, to yield a thickness for the negative photoresist layer 11 of about $0.5\times10^{-6}$M. Although a thickness of about $0.3\times10^{-6}$M would be sufficient for the layer 11 to be opaque with respect to the deep UV radiation, a thickness of about $0.5\times10^{-6}$M is preferred, in order to avoid pinhole problems. However, this thickness can also be anywhere in the approximate range of 0.4 to $0.8\times10^{-}$M. The resulting bilevel system 10 is then baked at about 70° Celcius for about 30 minutes.

As shown in Fig. 2, a deep UV projected light beam 21 is formed and directed through an opaque patterned mask (not shown) onto the bilevel system 10 by a standard optical projection system (not shown). The beam 21 is thereby focused to an image pattern of bright and dark regions (labeled B and D in Fig. 2) in the negative photoresist layer 11 in accordance with the pattern of the mask. The deep UV beam is supplied by a standard deep UV lamp source (not shown). The optics are such as to transmit deep UV of wavelengths in the range of about 0.200 to $0.240\times10^{-6}$M, for example, or alternatively 0.240 to $0.280\times10^{-6}$M. The UV source is typically a 500 watt xenon-mercury lamp. The UV radiation is typically about 100 millijoule/cm$^2$ or about 140 millijoule/cm$^2$, respectively for the abovementioned wavelength ranges. Next, as indicated in Fig. 3, development of the top layer 11 converts it into a patterned top layer 11.1, that is, patterned in accordance with the image of the mask 31. Specifically, the previously bright regions B remain and the previously dark regions D (Fig. 2) are removed by the development step. For example, this development can be accomplished by treatment with a solution of 1:4/MF312:$H_2O$ where MF312 is composed of hydroxides of ammonium ions.

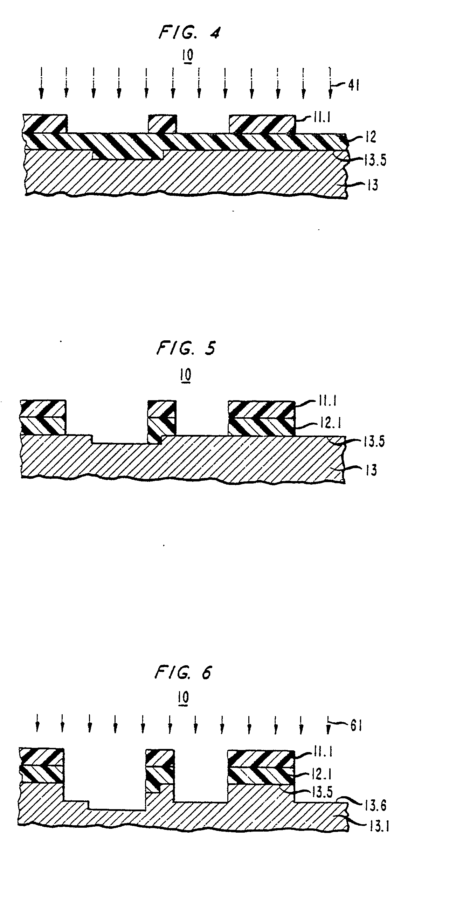

Then, after another baking (about 150° Celcius for about 60 minutes), the bilevel system 10 is subjected to another UV exposure. Specifically, as indicated in Fig. 4, a collimated (parallel) beam 41 of deep UV radiation is directed uniformly all over (floods) the top surface of the system. The beam 41 delivers a radiation dose of about 3000 milli-

joule/cm$^2$, for a range of wavelengths between about 0.200 and $0.240\times10^{-6}$M. The same deep UV source can thus be used for providing the beam 41 as for previously providing the beam 21 (Fig. 2). After development by treatment with a suitable solvent, such as methyl isobutyl ketone for about 60 seconds, the bottom photoresist layer 12 becomes a patterned bottom photoresist layer 12.1 as indicated in Fig. 5.

Finally, the system 10 is subjected to a standard chlorine plasma 61, (Fig. 6), in order anisotropically to remove (etch) the then exposed portions of the aluminum substrate 13. During this etching, the remaining patterned photoresist layer 11.1 and/or 12.1 inhibit any etching of the top surface 13.5 of the substrate 13 in regions thereof underlying the remaining portion of these photoresist layers. The resulting top surface 13.6 of the resulting patterned aluminum substrate 13.1 is thus at a lower horizontal level than the original top surface 13.5. Ordinarily the chlorine plasma etching is continued until the entire thickness of the aluminum is removed. The photoresist layers 11.1 and 12.1 can then be removed, as by a treatment with $O_2$ (oxygen) plasma.

Although the invention has been described in detail in terms of a specific embodiment, various modifications can be made without departing from the scope of the invention. For example, instead of PMMA, other positive organic photoresists can be used for the bottom photoresist layer such as poly(methyl methacrylate-co-3-oximino-2-butanone methacrylate) or "P(MOM)", poly(methyl methacrylate-co-3-oximino-2-butanone methacrylate-co-methacrylo nitrile) or "P(M-OM-CN)," poly(methyl isopropenyl ketone) or "PMIPK", or poly(methyl methacrylate-co-indenone) or "PMI"—all of which are photosensitive to deep UV in the wavelength range of about 0.240 to $0.280\times10^{-6}$M. Finally, instead of a xenon-mercury light source for the deep UV radiation, a mercury light source or a deep UV laser can be used.

## Claims

1. A method for making semiconductor devices comprising the steps of coating a substrate to be processed with a lower layer of photoresist, coating the lower layer with an upper layer of photoresist consisting of an organic material, using optical apparatus to project a focused image of first ultraviolet light on the upper layer, the substrate being reflective of the first ultraviolet light, developing the upper layer to form a first mask, exposing the masked lower layer to second ultraviolet light, developing the lower layer to form a second mask, and thereafter processing the substrate characterised in that the first ultraviolet light has a wavelength in the deep ultraviolet range, the upper layer is a negative photoresist consisting essentially of an azide-phenolic resin of diazodiphenyl sulfone mixed with poly(p-vinylphenol), is sufficiently thin to be within the depth of focus of the optical apparatus at the deep ultraviolet wavelength, is sensitive to deep ultraviolet light, and has a sufficient thickness to be opaque to the deep ultraviolet light.

2. The method of claim 1 characterised in that the second ultraviolet light is of the same wavelength as the first ultraviolet light.

3. The method of claim 2, characterised in that the lower layer is a positive photoresist.

4. The method of claim 3, characterised in that the upper layer has a thickness of 0.4—0.8 µm.

5. The method of claim 4 characterised in that the first and second ultraviolet light is supplied by a single xenon-mercury lamp.

## Patentansprüche

1. Verfahren zum Herstellen von Halbleitervorrichtungen umfassend die Schritte
— Beschichten eines zu bearbeitenden Substrates mit einer unteren Schicht eines Fotoresists,
— Beschichten der unteren Schicht mit einer oberen Schicht eines aus einem organischen Material bestehenden Fotoresists,
— Verwendung einer optischen Apparatur zur Pojektion eines fokussierten Bildes mit einem ersten UV-Licht auf die obere Schicht, wobei das Substrat für das erste UV-Licht reflektierend ist,
— Entwickeln der oberen Schicht zur Bildung einer ersten Maske,
— Aussetzen der maskierten unteren Schicht einem zweiten UV-Licht,
— Entwickeln der unteren Schicht zur Bildung einer zweiten Maske und
— nachfolgendes Bearbeiten des Substrates, dadurch gekennzeichnet, daß
— das erste UV-Licht eine Wellenlänge im fernen UV-Bereich besitzt,
— die obere Schicht
— ein Negativfotoresist, der im wesentlichen aus einem Azidphenolharz aus Diazodiphenylsulfon im Gemisch mit Poly(p-Vinylphenol) besteht, ist,
— ausreichend dünn ist, um innerhalb der Schärfentiefe der optischen Apparatur bei der Wellenlänge im fernen UV-Bereich zu liegen,
— gegenüber Licht des fernen UV-Bereichs empfindlich ist und
— eine ausreichende Dicke besitzt, um gegenüber dem Licht des fernen UV-Bereiches opak zu sein.

2. Verfahren nach Anspruch 1, dadurch gekennzeichnet, daß
— das zweite UV-Licht von derselben Wellenlänge wie das erste UV-Licht ist.

3. Verfahren nach Anspruch 2, dadurch gekennzeichnet, daß
— die untere Schicht ein Positivfotoresist ist.

4. Verfahren nach Anspruch 3, dadurch gekennzeichnet, daß
— die obere Schicht eine Dicke von 0,4 bis 0,8 µm besitzt.

5. Verfahren nach Anspruch 4, dadurch gekennzeichnet, daß
— das erste und zweite UV-Licht von einer einzigen Xenon-Quecksilber-Lampe geliefert wird.

## Revendications

1. Un procédé pour fabriquer des dispositifs à semiconducteurs comprenant les opérations qui consistent à déposer une couche inférieure de matière de réserve photosensible sur un substrat à traiter, à déposer sur la couche inférieure une couche supérieure de matière de réserve photosensible consistant en une matière organique, à utiliser un appareil optique pour projeter sur la couche supérieure une image au point d'une première lumière ultraviolette, le substrat étant réfléchissant pour la première lumière ultraviolette, à développer la couche supérieure pour former un premier masque, à exposer la couche inférieure masquée à une seconde lumière ultraviolette, à développer la couche inférieure pour former un second masque, et à traiter ensuite le substrat, caractérisé en ce que la première lumière ultraviolette a une longueur d'onde dans la gamme de l'ultraviolet lointain, la couche supérieure est formée par une matière de réserve photosensible négative consistant essentiellement en une résine azide-phénolique formée par une diazodiphénylsulfone mélangée avec du poly(p-vinylphénol), elle est suffisamment mince pour être comprise à l'intérieur de la profondeur de netteté de l'appareil optique pour la longueur d'onde dans l'ultraviolet lointain, elle est sensible à la lumière dans l'ultraviolet lointain et elle a une épaisseur suffisante pour être opaque à la lumière dans l'ultraviolet lointain.

2. Le procédé de la revendication 1 caractérisé en ce que la seconde lumière ultraviolette a la même longueur d'onde que la première lumière ultraviolette.

3. Le procédé de la revendication 2, caractérisé en ce que la couche inférieure consiste en une matière de réserve photosensible positive.

4. Le procédé de la revendication 3, caractérisé en ce que la couche supérieure a une épaisseur de 0,4—0,8 µm.

5. Le procédé de la revendication 4 caractérisé en ce que les première et seconde lumières ultraviolettes sont fournies par une seule lampe au xénon-mercure.

*FIG. 1*

10

*FIG. 2*

10

*FIG. 3*

10

FIG. 4

FIG. 5

FIG. 6